# EUROPÄISCHE PATENTSCHRIFT

(11) **EP 2 891 396 B1**
(45) Veröffentlichungstag und Bekanntmachung des Hinweises auf die Patenterteilung: **12.10.2016**
(21) Anmeldenummer: 13753412.9
(22) Anmeldetag: 08.08.2013
(51) Int. Cl.: H05K 7/20, F28D 15/02

(54) **KÜHLANORDNUNG FÜR IN EINEM INNENRAUM EINES SCHALTSCHRANKS ANGEORDNETE KOMPONENTEN**
COOLING ARRANGEMENT FOR COMPONENTS DISPOSED IN AN INTERIOR OF A SWITCH CABINET
DISPOSITIF DE REFROIDISSEMENT POUR DES COMPOSANTS PLACÉS DANS L'ESPACE INTERNE D'UNE ARMOIRE DE COMMANDE

(30) Priorität: 31.08.2012 DE 102012108110
(43) Veröffentlichungstag der Anmeldung: 08.07.2015
(73) Patentinhaber: Rittal GmbH & Co. KG, 35745 Herborn (DE)
(72) Erfinder: CACHO ALONSO, Juan Carlos, 35745 Herborn (DE)
(74) Vertreter: Angerhausen, Christoph
(86) Internationale Anmeldenummer: PCT/DE2013/100286
(87) Internationale Veröffentlichungsnummer: WO 2014/032649

(56) Entgegenhaltungen:
- DE-A1-102010 009 776

## Beschreibung

Die Erfindung betrifft eine Kühlanordnung für in einem Innenraum eines Schaltschranks angeordnete Komponenten, aufweisend einen Schaltschrank und ein Kühlgerät, das einen ersten geschlossenen Kühlmittelkreislauf mit einer Kältemaschine oder einem Kaltwassersatz aufweist, und wobei das Kühlgerät weiterhin einen ersten Luftgang mit einem ersten Lufteinlass und einem ersten Luftauslass, die zur Umgebung des Schaltschranks (1) geöffnet sind, und einen zweiten Luftgang mit einem zweiten Lufteinlass und einem zweiten Luftauslass, die zu einem Innenraum des Schaltschranks geöffnet sind, aufweist, wobei in dem ersten Luftgang ein Verflüssiger der Kältemaschine oder ein Luft-Wasser-Wärmetauscher des Kaltwassersatzes angeordnet ist, und wobei in dem zweiten Luftgang ein Verdampfer der Kältemaschine oder ein Luft-Wasser-Wärmetauscher des Kaltwassersatzes angeordnet ist. Eine derartige Kühlanordnung ist aus der DE 10 2010 009 776 A1 bekannt. Die DE 102 96 928 T5, DE 690 05 701 T2, US 2003/0057546 A1 und US 2012/0103571 A1 beschreiben ebenfalls jeweils eine ähnliche Anordnung.

Solche Kühlgeräte umfassen häufig eine Kältemaschine, bei welcher in einem Kühlmittelkreislauf in Kühlmittelströmungsrichtung hintereinander ein Verdichter, ein Verflüssiger, ein Expansionsmittel und ein Verdampfer angeordnet sind. Die Kältemaschine ist grundsätzlich darauf ausgelegt, bei Extrembedingungen, d. h. bei maximalen Umgebungstemperaturen und zugleich maximalen Verlustleistungen der in dem Schaltschrank aufgenommenen Komponenten eine hinreichende Kühlung des Schaltschrankinnenraums bereitzustellen. Da diese Extrembedingungen jedoch lediglich in Ausnahmefällen vorliegen, befindet sich die Kältemaschine die meiste Zeit im An-Aus-Betrieb, d. h. in einem energieuneffizienten Betriebsmodus.

Kältemaschinen haben darüber hinaus den Nachteil, einen vergleichsweise hohen Energieverbrauch aufzuweisen. Es ist daher grundsätzlich wünschenswert, zumindest anteilig die benötigte Kühlleistung mit Hilfe alternativer Kühltechniken bereitzustellen. Dazu sind aus dem Stand der Technik Kühlgeräte bekannt, welche einen Luft-Luft-Wärmetauscher mit einer Kältemaschine kombinieren, so dass bei einer ausreichend großen Temperaturdifferenz zwischen der Schaltschranksolltemperatur und der Umgebungslufttemperatur des Schaltschranks die benötigte Kühlleistung ausschließlich oder zumindest weitestgehend mit Hilfe des Luft-Luft-Wärmetauschers bereitgestellt werden kann. Solche kombinierten Kühlgeräte werden im weiteren Verlauf der Anmeldung auch als "Hybridkühlgeräte" bezeichnet. Hybridkühlgeräte, die einen Luft-Luft-Wärmetauscher aufweisen, haben den Nachteil, dass für den Fall, dass die Umgebungslufttemperatur über der Schaltschranktemperatur liegt, eine Erwärmung des Schaltschranks erfolgen würde, wenn der Luft-Luft-Wärmetauscher weiterhin mit warmer Umgebungsluft durchströmt würde, weshalb bei den aus dem Stand der Technik bekannten Kühlgeräten ein aufwendiger Klappenmechanismus dazu vorgesehen ist, in dem genannten Fall die Umgebungsluft von dem Wärmetauscher wegzuleiten. Diese Mechanismen sind jedoch sehr aufwendig und kompliziert in der Handhabung.

Im Allgemeinen werden Kühlkreisläufe, die eine Kältemaschine oder einen Kaltwassersatz aufweisen, die Kälte in das System einbringen und in der Regel zur Kühlung eines Kühlmediums dienen, als "aktive" Kühlkreisläufe bezeichnet. Der Kaltwassersatz kann im einfachsten Fall ein Kaltwasserreservoir aufweisen, wobei der Fachmann verstehen wird, dass "Wasser" bei Kühlanwendungen nicht beschränkend auszulegen ist, sondern lediglich als Synonym für die aus dem Stand der Technik bekannten Kühl- oder Kältemittel, allgemein als "Kühlmedium" bezeichnet, verwendet wird. "Passive" Kühlkreisläufe weisen dementsprechend keine Kältemaschine und keinen Kaltwassersatz auf. Bei diesen erfolgt keine aktive Kühlung eines Kühlmediums.

Es ist daher die Aufgabe der Erfindung, einen gattungsgemäßen Schaltschrank mit einem Kühlgerät bereitzustellen, bei dem das Kühlgerät mit einfachen technischen Mitteln ausgebildet uns auch für niedrige Temperaturdifferenzen zwischen der Schaltschranksolltemperatur und der Umgebungslufttemperatur des Schaltschranks passiv, d. h. ohne die Verwendung einer Kältemaschine oder eines Kaltwassersatzes, betrieben werden kann.

Diese Aufgabe wird erfindungsgemäß durch einen Schaltschrank mit den Merkmalen des Anspruchs 1 gelöst. Die abhängigen Ansprüche 2 bis 7 betreffen jeweils vorteilhafte Ausführungsformen der Erfindung.

Erfindungsgemäß weist das Kühlgerät weiterhin einen von dem ersten Kühlmittelkreislauf fluidisch getrennten zweiten Kühlmittelkreislauf mit einer Wärmerohranordnung oder einem Zwei-Phasen-Thermosiphon auf, wobei in dem ersten Luftgang eine Kondensationszone der Wärmerohranordnung oder des Zwei-Phasen-Thermosiphons angeordnet ist, wobei in dem zweiten Luftgang eine Verdampfungszone der Wärmerohranordnung oder des Zwei-Phasen-Thermosiphons angeordnet ist, und wobei die Kondensationszone und die Verdampfungszone jeweils einen Luft-Kühlmittel-Wärmetauscher aufweisen.

Vorzugweise umfasst die Wärmerohranordnung ein Gravitationswärmerohr, wobei die Verdampfungszone oberhalb von der Kondensationszone angeordnet ist. Dementsprechend sollten der erste und der zweite Luftgang zumindest bereichsweise derart zueinander angeordnet sein, dass die Kondensationszone zumindest abschnittsweise oberhalb von der Verdampfungszone angeordnet ist.

Um den Wirkungsgrad des erfindungsgemäßen Kühlgeräts zu steigern, ist bei einer Ausführungsform der Erfindung vorgesehen, dass der Verflüssiger der Kältemaschine in Luftströmungsrichtung durch den ersten Luftgang hinter der Kondensationszone der Wärmerohranordnung und der Verdampfer der Kältemaschine in Luftströmungsrichtung durch den zweiten Luftgang hinter der Verdampfungszone der Wärmerohranordnung angeordnet ist.

Zu demselben Zwecke kann bei einem Kühlgerät, das eine Wärmerohranordnung mit einem Kaltwassersatz kombiniert, vorgesehen sein, dass der Luft-Wasser-Wärmetauscher des Kaltwassersatzes in Luftströmungsrichtung durch den ersten Luftgang hinter der Kondensationszone der Wärmerohranordnung oder in Luftströmungsrichtung durch den zweiten Luftgang hinter der Verdampfungszone der Wärmerohranordnung angeordnet ist.

Um eine besonders kompakte Bauweise des ersten und des zweiten Kühlmittelkreislaufes sowie um einen Wärmeaustausch zwischen dem ersten und dem zweiten Kühlmittelkreislauf über den Luft-Kühlmittel-Wärmetauscher der Verdampfungszone zu erreichen, ist bei einer Ausführungsform der Erfindung vorgesehen, dass der Luft-Kühlmittel-Wärmetauscher der Verdampfungszone ein erstes Leitungssystem für ein erstes Kühlmittel und ein von dem ersten Leitungssystem fluidisch getrenntes zweites Leitungssystem für ein zweites Kühlmittel aufweist, wobei das erste und das zweite Leitungssystem thermisch miteinander gekoppelt sind, und wobei das erste Leitungssystem Bestandteil des ersten Kühlmittelkreislaufs und das zweite Leitungssystem Bestandteil des zweiten Kühlmittelkreislaufs ist.

Dabei kann das erste Leitungssystem des Luft-Kühlmittel-Wärmetauschers der Verdampfungszone einen Verdampfer der Kältemaschine oder einen Luft-Wasser-Wärmetauscher des Kaltwassersatzes aufweisen oder bilden.

Alternativ oder darüber hinaus kann der Luft-Kühlmittel-Wärmetauscher der Kondensationszone analog ein erstes Leitungssystem für ein erstes Kühlmittel und ein von dem ersten Leitungssystem fluidisch getrenntes zweites Leitungssystem für ein zweites Kühlmittel aufweisen, wobei das erste und das zweite Leitungssystem thermisch miteinander gekoppelt sind, und wobei das erste Leitungssystem Bestandteil des ersten Kühlmittelkreislaufs und das zweite Leitungssystem Bestandteil des zweiten Kühlmittelkreislaufs ist.

Ebenso kann bei der letztgenannten Ausführungsform das erste Leitungssystem des Luft-Kühlmittel-Wärmetauschers der Kondensationszone einen Verflüssiger der Kältemaschine oder einen Luft-Wasser-Wärmetauscher des Kaltwassersatzes aufweisen oder bilden.

Weitere Einzelheiten der Erfindung werden anhand der nachstehenden Figuren erläutert. Dabei zeigt:
- Figur 1: einen Wärmetauscher mit zwei fluidisch voneinander getrennten und thermisch gekoppelten Leitungssystemen;
- Figur 2: eine erfindungsgemäße Kühlanordnung mit einem als Wandanbaugerät ausgebildeten Kühlgerät mit einer Kältemaschine und einer Wärmerohranordnung;
- Figur 3: eine erfindungsgemäße Kühlanordnung mit einem als Wandanbaugerät ausgebildeten Kühlgerät mit einem Kaltwassersatz im Innenkreislauf;
- Figur 4: eine erfindungsgemäße Kühlanordnung mit einem als Wandanbaugerät ausgebildeten Kühlgerät mit einem Kaltwassersatz im Außenkreislauf;
- Figur 5: eine erfindungsgemäße Kühlanordnung mit einem als Dachaufbaugerät ausgebildeten Kühlgerät mit einem Kaltwassersatz im Innenkreislauf;
- Figur 6: eine erfindungsgemäße Kühlanordnung mit einem als Dachaufbaugerät ausgebildeten Kühlgerät mit einem Kaltwassersatz im Innenkreislauf;
- Figur 7: eine Wärmerohranordnung für die Verwendung in einem als Dachaufbaugerät ausgebildeten Kühlgerät gemäß den Figuren 5 und 6; und
- Figur 8: ein erfindungsgemäßes Kühlgerät, bei dem ein Expansionsmittel und ein Verdichter der Kältemaschine des ersten Kühlmittelkreislauf wahlweise überbrückbar sind.

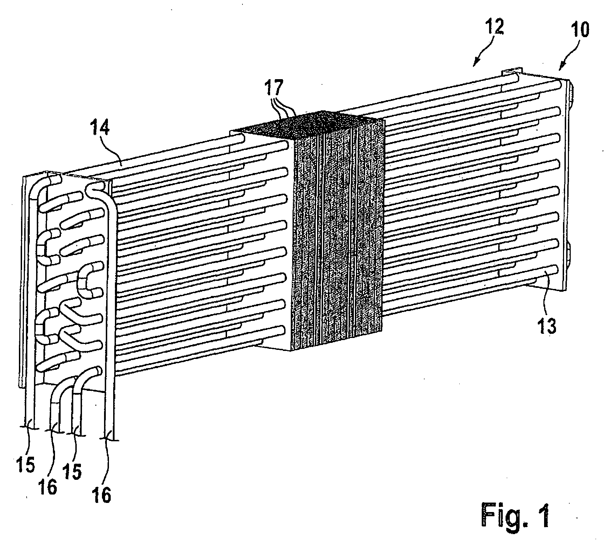

Bei der in Figur 1 dargestellten Ausführungsform eines Luft-Kühlmittel-Wärmetauschers 10 des zweiten Kühlmittelkreislaufes ist dieser einstückig mit einem Verdampfer bzw. einem Luft-Wasser-Wärmetauschers 12 des ersten Kühlmittelkreislaufes ausgebildet. Der Wärmetauscher 10 weist ein erstes Leitungssystem 13, in dem ein erstes Kühlmittel des ersten Kühlmittelkreislaufes geführt ist, und ein zweites Leitungssystem 14, in dem ein zweites Kühlmittel des zweiten Kühlmittelkreislaufes geführt ist, auf. Die Leitungssysteme 13, 14 sind jeweils aus parallelen Rohrbahnen zusammengesetzt, die sich zwischen zwei Längsenden des Wärmetauschers 10 erstrecken. An den Längsenden sind die parallelen Rohrleitungen derart miteinander verbunden, dass das Kühlmittel zwischen einem jeweiligen Kühlmittelvorlauf 15 und einem Kühlmittelrücklauf 16 geführt ist. Der in Figur 1 dargestellte Wärmetauscher 10 ist darauf ausgelegt, durch seine in der Darstellung vertikalen Längsseiten hindurch von einem Gas, beispielsweise Luft, durchströmt zu werden. Der Wärmetauscher 10 weist eine Mehrzahl Lamellen 17 auf, wobei benachbarte Lamellen 17 jeweils zwischen sich einen Luftströmungskanal durch den Wärmetauscher hindurch ausbilden. Darüber hinaus haben die Lamellen 17 die Aufgabe, das erste und das zweite Leitungssystem 13, 14 für den Wärmeaustausch thermisch miteinander zu koppeln. Bei der zuvor beschriebenen Strömungsrichtung der den Wärmetauscher 10 durchströmenden Luft sind das erste und das zweite Leitungssystem 13, 14 in Luftströmungsrichtung hintereinander angeordnet. Ist das erste Leitungssystem 13 Bestandteil eines eine Kältemaschine oder einen Kaltwassersatz aufweisenden Kühlkreislaufes und das zweite Leitungssystem 14 Bestandteil eines eine Wärmerohranordnung aufweisenden Kühlkreislaufes, und ist darüber hinaus vorgesehen, dass die Kühlung der den Wärmetauscher 10 durchströmenden Luft bevorzugt über die Wärmerohranordnung erfolgt, kann vorgesehen sein, dass die Kältemaschine bzw. der Kaltwassersatz nur dann in Betrieb genommen wird, wenn die über die Wärmerohranordnung bereitgestellte Kühlleistung nicht ausreicht. Da die beiden Kühlkreisläufe 13, 14 unabhängig voneinander ausgebildet sind, ist es für das Zuschalten der Kältemaschine bzw. des Kaltwassersatzes nicht notwendig, dass die Wärmerohranordnung deaktiviert wird. Wenn der aktive Kühlkreislauf außer Betrieb ist und die Kühlung somit über den passiven Kühlkreislauf erfolgen soll, dienen die Rohrleitungen des Leitungssystems 13 des aktiven Kühlkreislaufes in dem ersten Wärmetauscher 10 aufgrund der mit Hilfe der Lamellen 17 realisierten Wärmekopplung dazu, die Kühlleistung des Leitungssystems 14 des passiven Kühlkreislaufes zu erhöhen. Selbst wenn der aktive Kühlkreislauf somit außer Betrieb ist, ist dessen Leitungssystem 13 in dem Wärmetauscher 10 nicht nutzlos. Vielmehr dient dieses in diesem Fall zur Erhöhung des Wirkungsgrades des passiven Kühlkreislaufes.

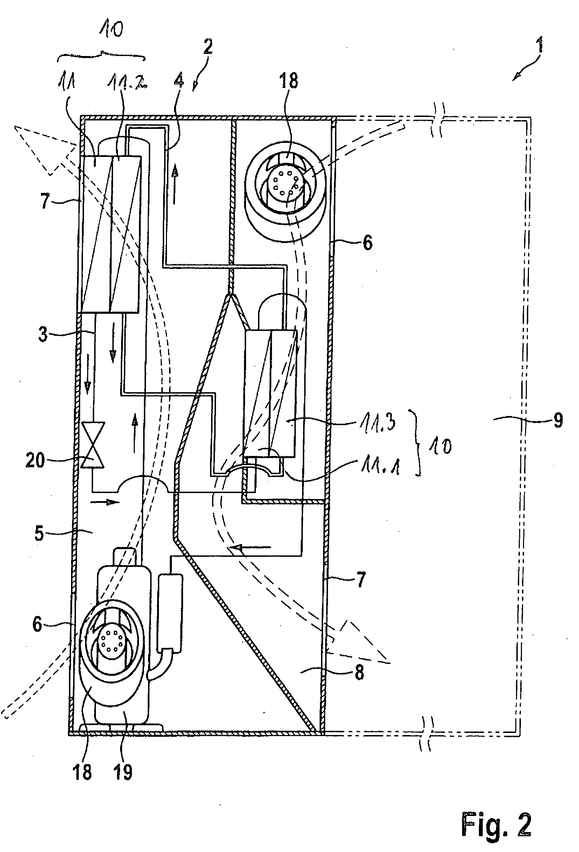

Die Figur 2 zeigt einen Schaltschrank 1, bei dem das Kühlgerät 2 als ein Wandanbaukühlgerät ausgebildet ist. Der Schaltschrank 1 umfasst einen Schaltschrankinnenraum 9, wobei an einer Außenwand des Schaltschranks 1 das Kühlgerät 2 angesetzt ist und wobei der Innenraum 9 des Schaltschranks 1 über einen Lufteinlass 6 und einen Luftauslass 7 mit dem zweiten Luftgang 8 des Kühlgeräts 2 fluidisch in Verbindung steht. Die in dem Schaltschrank 1 aufgenommene Luft wird mit Hilfe des Lüfters 18 durch den zweiten Luftgang 8 transportiert. In dem zweiten Luftgang 8 ist ein zweiter erfindungsgemäßer Wärmetauscher 10 gemäß Figur 1 angeordnet. Der Wärmetauscher in dem zweiten Luftgang 8 weist einen Verdampfer 11.1 und eine Verdampfungszone 11.3 einer Wärmerohranordnung auf, wobei die Verdampfungszone 11.3 in Luftströmungsrichtung durch den zweiten Luftgang 8 dem Verdampfer 11.1 vorgelagert ist. Fluidisch abgetrennt von dem zweiten Luftgang 8 weist das Kühlgerät 2 einen ersten Luftgang 5 auf, welcher über einen Lufteinlass 6 und einen Luftauslass 7 mit der Umgebung des Schaltschranks 1 fluidisch in Verbindung steht. Wiederum dient ein Lüfter 18 dazu, Umgebungsluft über den Einlass 6 in den ersten Luftgang 5 des Kühlgeräts 2 zu transportieren. In dem ersten Luftgang 5 ist ein erster erfindungsgemäßer Wärmetauscher 10 gemäß Figur 1 angeordnet, der von der durch den ersten Luftgang 5 geführten Luft durchströmt wird. Der Wärmetauscher in dem ersten Luftgang 5 weist einen Verflüssiger 11 und eine Kondensationszone 11.2 einer Wärmerohranordnung auf, wobei die Kondensationszone 11.2 in Luftströmungsrichtung durch den ersten Luftgang 5 dem Verflüssiger 11.1 vorgelagert ist. Die Wärmetauscher 10 stehen derart fluidisch miteinander in Verbindung, dass das erste Leitungssystem 13 des ersten Wärmetauschers 10 mit dem ersten Leitungssystem 13 des zweiten Wärmetauschers 10 einen ersten geschlossenen Kühlmittelkreislauf 3 und das zweite Leitungssystem 14 des ersten Wärmetauschers 10 mit dem zweiten Leitungssystem 14 des zweiten Wärmetauschers 10 einen zweiten geschlossenen Kühlmittelkreislauf 4 bildet.

Der erste geschlossene Kühlmittelkreislauf 3 ist bei der Ausführungsform gemäß Figur 2 ein Verdichter getriebener Kühlmittelkreislauf mit einem Verdichter 19 und einem Expansionsventil 20. Demzufolge hat der erste Wärmetauscher 10 soweit er den ersten geschlossenen Kühlmittelkreislauf 3 betrifft, die Funktion eines Kondensators und der zweite Wärmetauscher 10, soweit er den ersten geschlossenen Kühlmittelkreislauf 3 betrifft, die Funktion eines Verdampfers.

Der zweite geschlossene Kühlmittelkreislauf 4 bildet ein Wärmerohr, auch Heatpipe genannt. Dazu ist der erste Wärmetauscher 10 oberhalb des zweiten Wärmetauschers 10 angeordnet. Der zweite geschlossene Kühlmittelkreislauf 4 ist zumindest teilweise mit einem Kühlmittel gefüllt. Für Wärmerohranwendungen geeignete Kühlmittel sind aus dem Stand der Technik bekannt und können Wasser umfassen Das flüssige Kühlmittel lagert sich schwerkraftbedingt im unteren Bereich des zweiten geschlossenen Kühlmittelkreislaufes 4 ab, wo sich die Verdampfungszone des Wärmerohrs befindet. Diese bildet gerade der zweite Wärmetauscher 10. Der zweite Wärmetauscher 10 wird von der durch den zweiten Luftgang 8 transportierten warmen Schaltschrankluft durchströmt. Dabei erwärmt sich das Kühlmittel des zweiten geschlossenen Kühlmittelkreislaufes 4, woraufhin dieses zumindest teilweise verdampft. Das verdampfende Kühlmittel steigt in den ersten Wärmetauscher 10 auf, welcher gerade die Kondensationszone des Wärmerohrs bildet. Der erste Wärmetauscher 10 wird von der kühlen Umgebungsluft des Schaltschranks 1, welche durch den ersten Luftgang 5 mit Hilfe des Lüfters 18 transportiert wird, abgekühlt, woraufhin das gasförmige Kühlmittel in dem ersten Wärmetauscher 10 kondensiert. Das kondensierte Kühlmittel wandert schwerkraftgetrieben aus dem ersten Wärmetauscher 10 zurück in den tiefer gelegenen zweiten Wärmetauscher 10 und kann dort erneut verdampfen und erneut in den zweiten Wärmetauscher 10 aufsteigen.

Das Kühlgerät 2 gemäß Figur 2 kann somit wahlweise in drei verschiedenen Kühlmodi betrieben werden, nämlich ausschließlich aktiv, ausschließlich passiv, oder hybrid, wobei im Hybridbetrieb insbesondere vorgesehen sein kann, dass der passive Kühlprozess permanent betrieben wird, während der aktive Kühlprozess dazu dient, die mit Hilfe des passiven Kühlprozesses bereitgestellte Kühlleistung soweit zu ergänzen, dass in Summe mindestens die geforderte Kühlleistung zur Verfügung gestellt wird, wozu der aktive Kühlprozess getaktet wird.

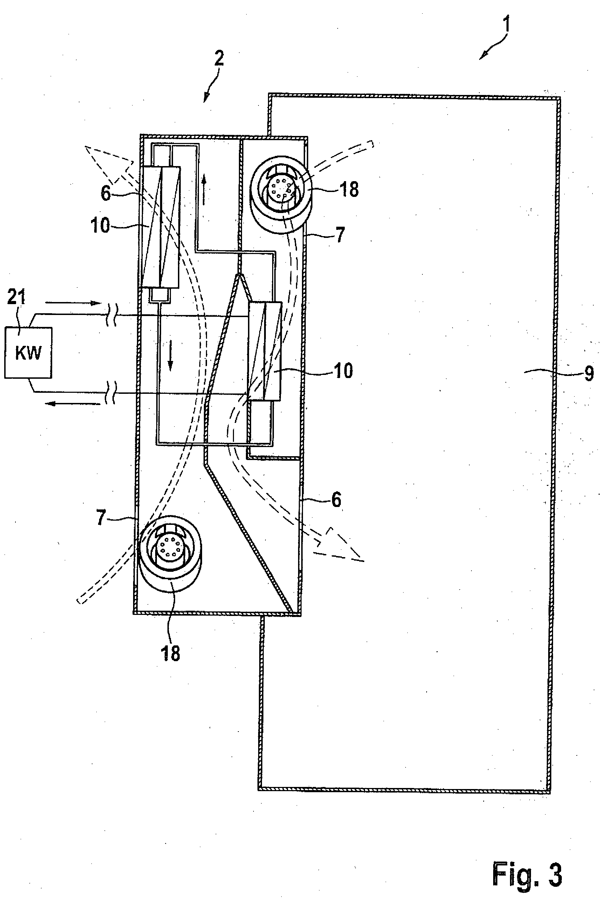

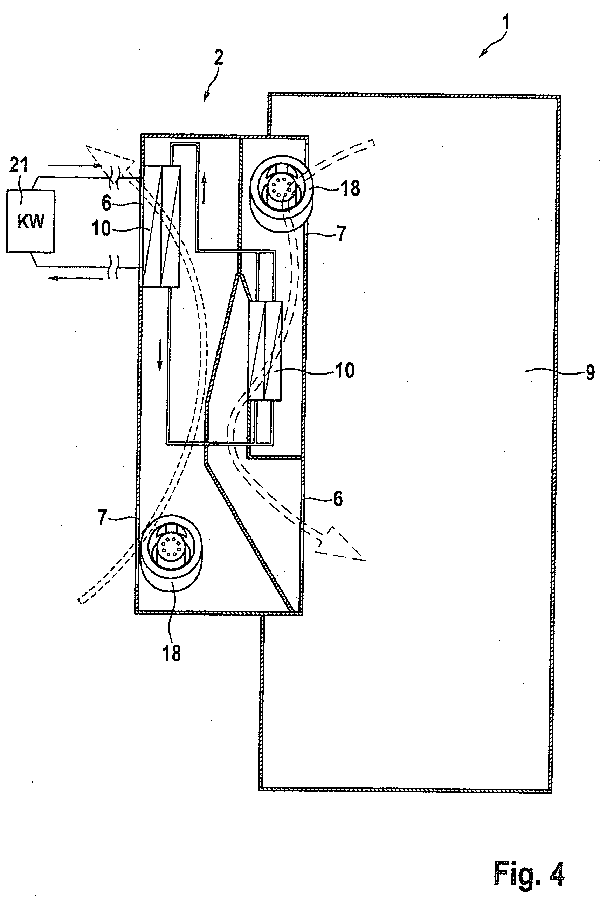

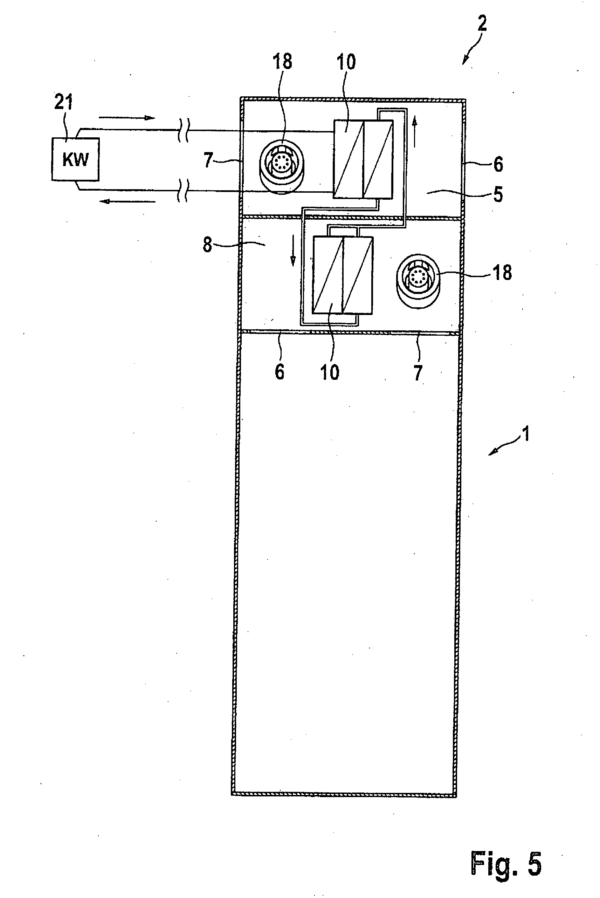

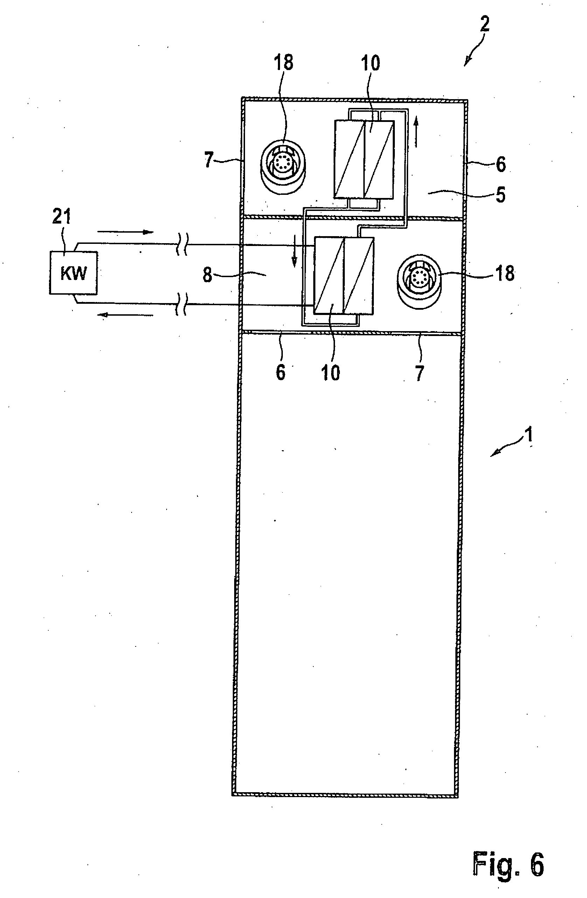

In den Figuren 3 bis 6 ist dargestellt, dass im Wesentlichen ein und derselbe Kühlgerätaufbau dazu dienen kann, eine ganze Vielfalt von unterschiedlichen Kühlprozessen zu realisieren. Dabei betreffen die Ausführungsformen gemäß den Figuren 3 und 4 Wandkühlgeräte und die Ausführungsformen gemäß den Figuren 5 und 6 Kühlgeräte, die als Dachaufbauten ausgebildet sind.

Figur 3 zeigt ein Hybridkühlgerät mit einem Kaltwassersatz im Innenkreislauf. Das erste und das zweite Leitungssystem 13, 14 des ersten Wärmetauschers 10 im ersten Luftgang 5 sind in Reihe geschaltet, wobei diese mit dem zweiten Leitungssysteme 14 des zweiten Wärmetauschers 10 ein Wärmerohr bilden. Das verbleibende zweite Leitungssystem 14 des zweiten Wärmetauschers 10 bildet mit einer Kaltwasserquelle 21 den zweiten geschlossenen Kühlmittelkreislauf 4 und damit einen Kaltwassersatz. Die Kaltwasserquelle 21 stellt gekühltes Wasser bereit, welches durch den zweiten Wärmetauscher 10 zirkuliert wird und ist nicht Bestandteil des Kühlgeräts 2. Dieser zusätzliche aktive Kühlmittelkreislauf 4 kann somit dazu dienen, entweder bei hohen Verlustleistungen der in dem Schaltschrankinnenraum 9 aufgenommenen Komponenten oder bei hohen Umgebungstemperaturen des Schaltschrankes 1 eine zusätzliche Kühlleistung zur Verfügung zu stellen, welche die mit Hilfe des passiven Kühlkreislaufes 3 bereitgestellte Kühlleistung soweit ergänzt, dass in Summe eine ausreichende Schaltschrankkühlung zur Verfügung gestellt wird.

Insbesondere bei hohen Umgebungstemperaturen kann es entsprechend dem Aufbau gemäß Figur 4 zweckmäßig sein, den zusätzlichen aktiven Kühlmittelkreislauf 4 mit Hilfe des in den zweiten Luftgang 8 integrierten Wärmetauschers 10 zu realisieren. Hier umfasst der aktive Kühlmittelkreislauf wiederum einen Kaltwassersatz.

Die Figuren 5 und 6 zeigen, dass analog zu den Figuren 3 und 4 Kühlgeräte 2 für den Dachaufbau realisiert werden können, welche die erfindungsgemäße hohe Variabilität aufweisen. Auch bei Kühlgeräten, die als Dachaufbauten realisiert sind, ist es dem Anwender freigestellt, den aktiven Kühlmittelkreislauf 4 neben dem passiven Kühlmittelkreislauf 3 entweder im Außenkreis über den ersten Wärmetauscher 10 (siehe Figur 5), oder im Innenkreis über den zweiten Wärmetauscher 10 (siehe Figur 6) zu realisieren.

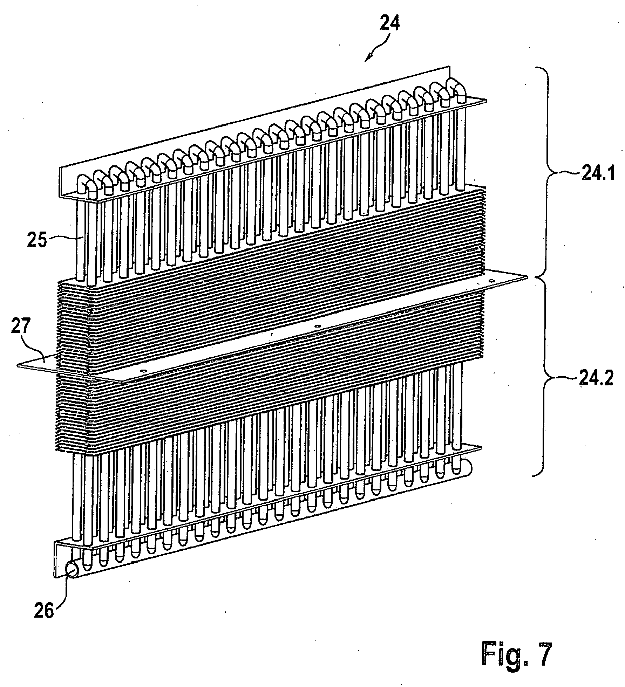

Figur 7 zeigt eine beispielhafte Ausführungsform einer Wärmerohranordnung, wie sie insbesondere in Dachaufbaukühlgeräten Anwendung finden kann.

Die Wärmerohranordnung 24 umfasst ein Leitungssystem, das aus vertikal geführten Rohrabschnitten 25 zusammengesetzt sind. Die Rohrabschnitte 25 bestehen jeweils aus Paaren paralleler Rohrleitungen, welche an ihrem oberen Ende mit Hilfe eines U-förmigen Umlenkstücks fluidisch miteinander verbunden sind. Am unteren Ende jedes Rohrabschnitts 25 münden die Rohrleitungen jedes Rohrabschnitts 25 in ein gemeinsames Sammelrohr 26, welches die Rohrabschnitte 25 fluidisch miteinander verbindet. Die Wärmerohranordnung 24 ist über eine sich horizontal erstreckende Endlamelle 27 in eine Kondensationszone 24.1 und eine Verdampfungszone 24.2 unterteilt, wobei bei montiertem Luft-Luft-Wärmetauscher 10 die Kondensationszone 24.1 in dem ersten Luftgang des Kühlgeräts und die Verdampfungszone 24.2 in dem zweiten Luftgang des Kühlgeräts angeordnet ist. Die Endlamelle 27 dient zur Positionierung und Befestigung der Wärmerohranordnung 24 an einem Durchlass, der in einer Zwischenwand, die den ersten Luftgang von dem zweiten Luftgang abtrennt, ausgebildet ist. Die Rohrleitungen der Rohrabschnitte 25 sind durch sich horizontal erstreckende, thermisch leitfähige Lamellen 17 hindurch geführt und an diese thermisch gekoppelt, wobei zwischen benachbarten Lamellen 17 jeweils ein Luftführungsschlitz ausgebildet ist. Die Lamellen 17 erstrecken sich somit gerade in Bewegungsrichtung der durch den ersten Luftgang beziehungsweise der durch den zweiten Luftgang transportierten Luft und dienen dazu, den Wärmeaustausch zwischen der Verdampfungszone 24.2 beziehungsweise der Kondensationszone 24.1 und der durch den jeweiligen Luftgang hindurch geführten Luft zu verbessern.

In dem Leitungssystem der Wärmerohranordnung 24 ist ein Kältemittel vorgehalten, welches sich aufgrund der vertikalen Ausrichtung der Rohrabschnitte 25 Schwerkraft getrieben vor allem im unteren Bereich der Wärmerohranordnung 24 und damit in dem Sammelrohr 26 sowie in der Verdampfungszone 24.2 ansammelt. Erfindungsgemäß ist die Vedampfungszone 24.2 gerade im zweiten Luftgang 8 des Kühlgeräts angeordnet und wird damit von der warmen Luft aus dem Schaltschrankinnenraum 9 durchströmt. Die warme Luft kann über die Rohrleitungen beziehungsweise die thermisch leitfähigen Lamellen 17 Wärme an das Kühlmittel in der Verdampfungszone 24.2 abtauschen, welches daraufhin vom flüssigen Aggregatzustand in den gasförmigen Aggregatzustand übergeht und entlang der Rohrleitungen in die Kondensationszone 24.1 der Wärmerohranordnung 24 wandert. Die Kondensationszone 24.1 soll sich erfindungsgemäß gerade im ersten Luftgang 5 des Kühlgeräts 2 befinden, so dass diese gerade von der kühlen Umgebungsluft des Schaltschranks 1 umströmt wird. Dies hat zur Folge, dass das gasförmige Kältemittel, welches in der Kondensationszone 24.1 der Wärmerohranordnung 24 vorgehalten ist, Wärmeenergie an die durch den ersten Luftgang 3 transportierte Umgebungsluft abtauschen kann, woraufhin dieses kondensiert und Schwerkraft getrieben aus der Kondensationszone 24.1 in die Verdampfungszone 24.2 zurückfließt.

Es ist verständlich, dass das Leitungssystem und insbesondere dessen Rohrabschnitte nicht exakt vertikal ausgerichtet sein müssen, damit die zuvor beschriebene Funktionalität erreicht werden kann. Vielmehr ist auch eine angewinkelte Anordnung der Wärmerohranordnung 24 in dem Kühlgerät denkbar, beispielsweise um ein platzsparendes, weniger hoch bauendes Kühlgerät zu erzielen.

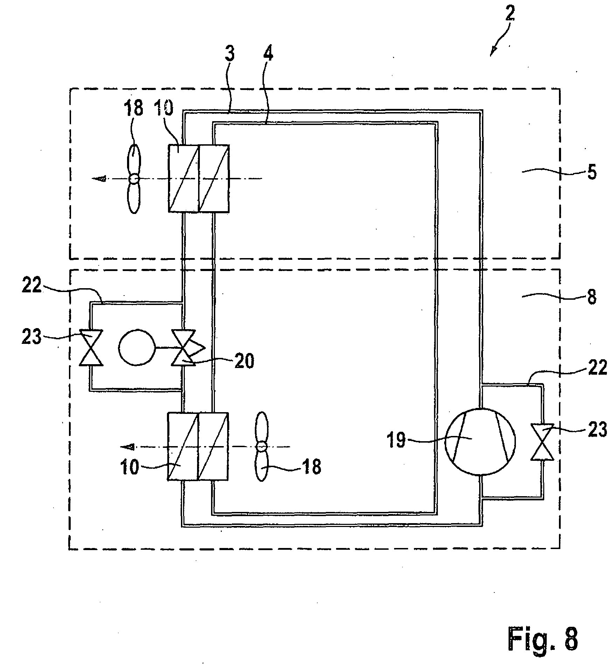

Die Figur 8 beschreibt schematisch eine alternative Ausführungsform des erfindungsgemäßen Hybridkühlgeräts 2, mit einem ersten und einem zweiten erfindungsgemäßen Wärmetauscher 10, die einen ersten geschlossenen Kühlmittelkreislauf 3 und einen zweiten geschlossenen Kühlmittelkreislauf 4 thermisch miteinander koppeln. Der erste geschlossene Kühlmittelkreislauf 3 ist ein aktiver Kühlmittelkreislauf, der in Kühlmittelströmungsrichtung hintereinander einen Verdichter 19, einen Verflüssiger in Form des oberen Wärmetauschers 10, ein Expansionsventil 20 und einen Verdampfer in Form des unteren Wärmetauschers 10 aufweist. Der Verdichter 19 und das Expansionsventil 20 sind über eine Bypassleitung 22, die jeweils ein Ventil 23 aufweist, überbrückt. In der Schließstellung der Ventile 23 kann der erste geschlossene Kühlmittelkreislauf 3 aktiv betrieben werden. Sind die Ventile 23 geöffnet, bilden die Wärmetauscher 10 eine Wärmerohranordnung und somit einen passiven Kühlmittelkreislauf. Die beiden Kühlmittelkreisläufe 3, 4 sind derart zueinander angeordnet, dass die jeweiligen Kältemittel in entgegengesetzter Richtung zueinander transportiert werden, wenn der erste Kühlmittelkreislauf 3 aktiv betrieben wird. In dem zweiten Kühlmittelkreislauf 4 ist ein zweites Kühlmittel zwischen dem Verdampfer und dem Verflüssiger geführt. Der Verflüssiger und der Verdampfer sind jeweils derart ausgestaltet, dass die beiden Kühlmittelkreisläufe 3, 4 über den Verdampfer und den Verflüssiger thermisch miteinander gekoppelt sind. Der Verlüssiger ist um einen vertikalen Abstand oberhalb von dem Verlüssiger angeordnet. Der Verflüssiger ist in einem von einem ersten Teilgehäuse des Kühlgeräts gebildeten ersten Luftgang 5 des Kühlgeräts 2 und der Verdampfer sowie der Verdichter 19 und das Expansionsventil 20 sind in einem von einem zweiten Teilgehäuse des Kühlgeräts 2 gebildeten zweiten Luftgang 8 angeordnet. Durch den ersten Luftgang 5 und insbesondere den Verflüssiger wird Umgebungsluft des Schaltschranks 1 mit Hilfe eines Lüfters 18 transportiert. Durch den zweiten Luftgang 8 und insbesondere den Verdampfer wird erwärmte Luft aus dem Schaltschrankinnern mit Hilfe eines weiteren Lüfters 18 transportiert. Die Ventile 23 in den Bypassleitungen 22 sind vorzugsweise elektrisch ansteuerbare Magnetventile.

Das zweite Kühlmittel in dem zweiten Kühlmittelkreislauf 4 wird über die warme Schaltschrankluft, welche durch den zweiten Luftgang 8 transportiert wird, erwärmt, woraufhin dieses zumindest teilweise verdampft oder seine Dichte zumindest insoweit verringert, dass es entlang dem zweiten Kühlmittelkreislauf 4 von dem Verdampfer in den Verflüssiger transportiert wird. Der Verflüssiger wird von kühler Umgebungsluft des Schaltsschranks umströmt. Dadurch kondensiert bzw. verdichtet sich das Kühlmittel derart, dass es entlang dem Kühlmittelkreislauf 4 zurück in den Verdampfer fließt, um dort erneut von der warmen Schaltschrankluft erwärmt zu werden. Befindet sich der erste Kühlmittelkreislauf 3 ebenso im passiven Betriebsmodus, kann auch in diesem das Kältemittel in der zuvor mit Bezug auf den zweiten Kühlmittelkreislauf 4 beschriebenen Weise zwischen dem Verdampfer und dem Verflüssiger zirkulieren. In diesem Fall ist die Transportrichtung des ersten Kühlmittels in dem ersten Kühlmittelkreislauf 3 entgegen der eingezeichneten Strömungsrichtung x. Die eingezeichnete Strömungsrichtung x des ersten Kühlmittels in dem ersten Kühlmittelkreislauf 3 entspricht derjenigen, welche sich bei dem aktiven Betrieb des ersten Kühlmittelkreislaufes 3 einstellt.

**Bezugszeichenliste**

| | | | |
|---|---|---|---|
| 1 | Schaltschrank | 25 | vertikale Rohrabschnitte |
| 2 | Kühlgerät | 26 | Sammelrohr |
| 3 | erster geschlossener Kühlmittelkreislauf | 27 | Endlamelle |
| 4 | zweiter geschlossener Kühlmittelkreislauf | | |
| 5 | erster Luftgang | | |
| 6 | Lufteinlass | | |
| 7 | Luftauslass | | |
| 8 | zweiter Luftgang | | |
| 9 | Innenraum des Schaltschranks | | |
| 10 | Luft-Kühlmittel-Wärmetauscher | | |
| 11 | Verflüssiger | | |
| 11.1 | Verdampfer | | |
| 11.2 | Kondensationszone | | |
| 11.3 | Verdampfungszone | | |
| 12 | Luft-Wasser-Wärmetauscher | | |
| 13 | erstes Leitungssystem | | |
| 14 | zweites Leitungssystem | | |
| 15 | Kühlmittelvorlauf | | |
| 16 | Kühlmittelrücklauf | | |
| 17 | Lamellen | | |
| 18 | Lüfter | | |
| 19 | Verdichter | | |
| 20 | Expansionsventil | | |
| 21 | Kaltwasserquelle | | |
| 22 | Bypassleitung | | |
| 23 | Ventil | | |
| 24 | Wärmerohranordnung | | |
| 24.1 | Kondensationszone | | |
| 24.2 | Verdampfungszone | | |

## Patentansprüche

1. Kühlanordnung für in einem Innenraum (9) eines Schaltschranks (1) angeordnete Komponenten, aufweisend einen Schaltschrank (1) und ein Kühlgerät (2), das einen ersten geschlossenen Kühlmittelkreislauf (3) mit einer Kältemaschine oder einem Kaltwassersatz aufweist, und wobei
das Kühlgerät (2) weiterhin einen ersten Luftgang (5) mit einem ersten Lufteinlass (6) und einem ersten Luftauslass (7), die zur Umgebung des Schaltschranks (1) geöffnet sind, und einen zweiten Luftgang (8) mit einem zweiten Lufteinlass (6) und einem zweiten Luftauslass (7), die zu einem Innenraum (9) des Schaltschranks (1) geöffnet sind, aufweist, wobei in dem ersten Luftgang (5) ein Verflüssiger (11) der Kältemaschine oder ein Luft-Wasser-Wärmetauscher (12) des Kaltwassersatzes angeordnet ist, und wobei in dem zweiten Luftgang (8) ein Verdampfer der Kältemaschine oder ein Luft-Wasser-Wärmetauscher (12) des Kaltwassersatzes angeordnet ist, **dadurch gekennzeichnet, dass** das Kühlgerät weiterhin einen von dem ersten Kühlmittelkreislauf (3) fluidisch getrennten zweiten Kühlmittelkreislauf (4) mit einer Wärmerohranordnung oder einem Zwei-Phasen-Thermosiphon aufweist, wobei in dem ersten Luftgang (5) eine Kondensationszone der Wärmerohranordnung oder des Zwei-Phasen-Thermosiphons angeordnet ist, wobei in dem zweiten Luftgang (8) eine Verdampfungszone der Wärmerohranordnung oder des Zwei-Phasen-Thermosiphons angeordnet ist, und wobei die Kondensationszone und die Verdampfungszone jeweils einen Luft-Kühlmittel-Wärmetauscher (10) aufweisen.

2. Kühlanordnung nach Anspruch 1, bei der der Verflüssiger (11) der Kältemaschine in Luftströmungsrichtung durch den ersten Luftgang hinter der Kondensationszone (11.2) der Wärmerohranordnung und der Verdampfer (11.1) der Kältemaschine in Luftströmungsrichtung durch den zweiten Luftgang hinter der Verdampfungszone (11.3) der Wärmerohranordnung angeordnet ist.

3. Kühlanordnung nach Anspruch 1, bei der der Luft-Wasser-Wärmetauscher des Kaltwassersatzes in Luftströmungsrichtung durch den ersten Luftgang hinter der Kondensationszone der Wärmerohranordnung oder in Luftströmungsrichtung durch den zweiten Luftgang hinter der Verdampfungszone der Wärmerohranordnung angeordnet ist.

4. Kühlanordnung nach einem der Ansprüche 1 bis 3, bei der der Luft-Kühlmittel-Wärmetauscher (10) der Verdampfungszone ein erstes Leitungssystem (13) für ein erstes Kühlmittel und ein von dem ersten Leitungssystem (13) fluidisch getrenntes zweites Leitungssystem (14) für ein zweites Kühlmittel aufweist, wobei das erste und das zweite Leitungssystem (13, 14) thermisch miteinander gekoppelt sind, und wobei das erste Leitungssystem (13) Bestandteil des ersten Kühlmittelkreislaufs (3) und das zweite Leitungssystem (14) Bestandteil des zweiten Kühlmittelkreislaufs (4) ist.

5. Kühlanordnung nach Anspruch 4, bei der das erste Leitungssystem (13) des Luft-Kühlmittel-Wärmetauschers (10) der Verdampfungszone einen Verdampfer der Kältemaschine oder einen Luft-Wasser-Wärmetauscher des Kaltwassersatzes aufweist oder bildet.

6. Kühlanordnung nach einem der Ansprüche 1 bis 5, bei der der Luft-Kühlmittel-Wärmetauscher (10) der Kondensationszone ein erstes Leitungssystem (13) für ein erstes Kühlmittel und ein von dem ersten Leitungssystem (13) fluidisch getrenntes zweites Leitungssystem (14) für ein zweites Kühlmittel aufweist, wobei das erste und das zweite Leitungssystem (13, 14) thermisch miteinander gekoppelt sind, und wobei das erste Leitungssystem (13) Bestandteil des ersten Kühlmittelkreislaufs (3) und das zweite Leitungssystem (14) Bestandteil des zweiten Kühlmittelkreislaufs (4) ist.

7. Kühlanordnung nach Anspruch 6, bei der das erste Leitungssystem (13) des Luft-Kühlmittel-Wärmetauschers (10) der Kondensationszone einen Verflüssiger der Kältemaschine oder einen Luft-Wasser-Wärmetauscher des Kaltwassersatzes aufweist oder bildet.

## Claims

1. A cooling arrangement for components disposed in an interior (9) of a switch cabinet (1), having a switch cabinet (1) and a cooling apparatus (2) which has a first closed coolant circuit (3) and a second coolant circuit (4) separated fluidically therefrom, the first coolant circuit (3) having a refrigerating machine or a cold water set and the second coolant circuit (4) having a heat pipe arrangement or a two-phase thermosiphon, and the cooling apparatus (2) having, furthermore, a first air passage (5) with a first air inlet (6) and a first air outlet (7), which are open to the surroundings of the switch cabinet (1), and a second air passage (8) with a second air inlet (6) and a second air outlet (7), which are open to an interior (9) of the switch cabinet (1), a condenser (11) of the refrigerating machine or an air/water heat exchanger (12) of the cold water set and a condensation zone of the heat pipe arrangement or of the two-phase thermosiphon being disposed in the first air passage (5), and an evaporator of the refrigerating machine or an air/water heat exchanger (12) of the cold water set and an evaporation zone of the heat pipe arrangement or of the two-phase thermosiphon being disposed in the second air passage (8), and the condensation zone and the evaporation zone having in each case an air/coolant heat exchanger (10).

2. The cooling arrangement as claimed in claim 1, in which the condenser (11) of the refrigerating machine is disposed downstream of the condensation zone (11.2) of the heat pipe arrangement in the air flow direction through the first air passage, and the evaporator (11.1) of the refrigerating machine is disposed downstream of the evaporation zone (11.3) of the heat pipe arrangement in the air flow direction through the second air passage.

3. The cooling arrangement as claimed in claim 1, in which the air/water heat exchanger of the cold water set is disposed downstream of the condensation zone of the heat pipe arrangement in the air flow direction through the first air passage or downstream of the evaporation zone of the heat pipe arrangement in the air flow direction through the second air passage.

4. The cooling arrangement as claimed in one of claims 1 to 3, in which the air/coolant heat exchanger (10) of the evaporation zone has a first line system (13) for a first coolant and a second line system (14), separated fluidically from the first line system (13), for a second coolant, the first and the second line system (13, 14) being coupled thermally to one another, and the first line system (13) being an integral part of the first coolant circuit (3) and the second line system (14) being an integral part of the second coolant circuit (4).

5. The cooling arrangement as claimed in claim 4, in which the first line system (13) of the air/coolant heat exchanger (10) of the evaporation zone has or forms an evaporator of the refrigerating machine or an air/water heat exchanger of the cold water set.

6. The cooling arrangement as claimed in one of claims 1 to 5, in which the air/coolant heat exchanger (10) of the condensation zone has a first line system (13) for a first coolant and a second line system (14), separated fluidically from the first line system (13), for a second coolant, the first and the second line system (13, 14) being coupled thermally to one another, and the first line system (13) being an integral part of the first coolant circuit (3) and the second line system (14) being an integral part of the second coolant circuit (4).

7. The cooling arrangement as claimed in claim 6, in which the first line system (13) of the air/coolant heat exchanger (10) of the condensation zone has or forms a condenser of the refrigerating machine or an air/water heat exchanger of the cold water set.

## Revendications

1. Dispositif de refroidissement pour des composants disposés dans un espace intérieur (9) d'une armoire de commande (1), présentant une armoire de commande (1) et un appareil frigorifique (2) qui présente un premier circuit de fluide de refroidissement (3) fermé avec une machine frigorifique ou un groupe de production d'eau glacée, et
l'appareil frigorifique (2) présentant également un premier passage d'air (5) avec une première entrée d'air (6) et une première sortie d'air (7) qui sont ouvertes vers l'environnement de l'armoire de commande (1), et un deuxième passage d'air (8) avec une deuxième entrée d'air (6) et une deuxième sortie d'air (7) qui sont ouvertes vers un espace intérieur (9) de l'armoire de commande (1), un condenseur (11) de la machine frigorifique ou un échangeur de chaleur air-eau (12) du groupe de production d'eau glacée étant disposé dans le premier passage d'air (5), et un évaporateur de la machine frigorifique ou un échangeur de chaleur air-eau (12) du groupe de production d'eau glacée étant disposé dans le deuxième passage d'air (8), **caractérisé en ce que** l'appareil frigorifique présente également un deuxième circuit de fluide de refroidissement (4), fluidiquement séparé du premier circuit de fluide de refroidissement (3), avec un dispositif de caloduc ou un thermosiphon à deux phases, une zone de condensation du dispositif de caloduc ou du thermosiphon à deux phases étant disposée dans le premier passage d'air (5), une zone d'évaporation du dispositif de caloduc ou du thermosiphon à deux phases étant disposée dans le deuxième passage d'air (8), et la zone de condensation et la zone d'évaporation présentant respectivement un échangeur de chaleur air-fluide de refroidissement (10).

2. Dispositif de refroidissement selon la revendication 1, dans lequel le condenseur (11) de la machine frigorifique est, dans la direction d'écoulement d'air à travers le premier passage d'air, disposé derrière la zone de condensation (11.2) du dispositif de caloduc, et l'évaporateur (11.1) de la machine frigorifique est, dans la direction d'écoulement d'air à travers le deuxième passage d'air, disposé derrière la zone d'évaporation (11.3) du dispositif de caloduc.

3. Dispositif de refroidissement selon la revendication 1, dans lequel l'échangeur de chaleur air-eau du groupe de production d'eau glacée est, dans la direction d'écoulement d'air à travers le premier passage d'air, disposé derrière la zone de condensation du dispositif de caloduc ou est, dans la direction d'écoulement d'air à travers le deuxième passage d'air, disposé derrière la zone d'évaporation du dispositif de caloduc.

4. Dispositif de refroidissement selon l'une des revendications 1 à 3, dans lequel l'échangeur de chaleur air-fluide de refroidissement (10) de la zone d'évaporation présente un premier système de conduites (13) pour un premier fluide de refroidissement et un deuxième système de conduites (14), fluidiquement séparé du premier système de conduites (13), pour un deuxième fluide de refroidissement, le premier et le deuxième système de conduites (13, 14) étant couplés thermiquement l'un à l'autre, et le premier système de conduites (13) faisant partie du premier circuit de fluide de refroidissement (3) et le deuxième système de conduites (14) faisant partie du deuxième circuit de fluide de refroidissement (4).

5. Dispositif de refroidissement selon la revendication 4, dans lequel le premier système de conduites (13) de l'échangeur de chaleur air-fluide de refroidissement (10) de la zone d'évaporation présente ou forme un évaporateur de la machine frigorifique ou un échangeur de chaleur air-eau du groupe de production d'eau glacée.

6. Dispositif de refroidissement selon l'une des revendications 1 à 5, dans lequel l'échangeur de chaleur air-fluide de refroidissement (10) de la zone de condensation présente un premier système de conduites (13) pour un premier fluide de refroidissement et un deuxième système de conduites (14), fluidiquement séparé du premier système de conduites (13), pour un deuxième fluide de refroidissement, dans lequel le premier et le deuxième système de conduites (13, 14) sont couplés thermiquement l'un à l'autre, et dans lequel le premier système de conduites (13) fait partie du premier circuit de fluide de refroidissement (3) et le deuxième système de conduites (14) fait partie du deuxième circuit de fluide de refroidissement (4).

7. Dispositif de refroidissement selon la revendication 6, dans lequel le premier système de conduites (13) de l'échangeur de chaleur air-fluide de refroidissement (10) de la zone de condensation présente ou forme un évaporateur de la machine frigorifique ou un échangeur de chaleur air-eau du groupe de production d'eau glacée.
